# EUROPÄISCHE PATENTANMELDUNG

(11) **EP 3 026 015 A1**
(43) Veröffentlichungstag der Anmeldung: **01.06.2016**
(21) Anmeldenummer: 14195300.0
(22) Anmeldetag: 28.11.2014
(51) Int. Cl.: C01B 33/03, C01B 33/027, C01B 33/029

(54) **VERFAHREN ZUR HERSTELLUNG VON SILICIUM HOHLKÖRPERN**

(71) Anmelder: Evonik Degussa GmbH, 45128 Essen (DE)
(72) Erfinder: Lang, Jürgen Erwin, 76229 Karlsruhe (DE); Rauleder, Hartwig, 79618 Rheinfelden (DE); Lyubina, Julia, 63457 Hanau (DE); Marinas Pérez, Janaina, 79730 Murg (DE)

(57) **Zusammenfassung**

Die Erfindung betrifft Verfahren zur Herstellung von Hohlkörpern mit einer Silicium aufweisenden Hülle, indem man zumindest ein Silan in einem nichtthermischen Plasma, mittels einer Pyrolyse, Eintrag elektromagnetischer Energie, oder in einem Lichtbogen umsetzt, anschließend in einem Benetzungsmittel dispergiert und destilliert und anschließend in einem Ätzvorgang umsetzt

## Beschreibung

Die Erfindung betrifft Verfahren zur Herstellung von Hohlkörpern mit einer Silicium aufweisenden Hülle, indem man zumindest ein Silan in einem Lichtbogen bzw. in einem Plasma, bevorzugt in einem Plasma das im nichtthermischen Gleichgewicht betrieben wird oder mittels elektromagnetischer Wellen umsetzt bzw. pyrolysiert, anschließend in einem Lösungsmittel dispergiert und destilliert und anschließend in einem Ätzvorgang umsetzt wird.

Metallische und halbmetallische Partikel wie zum Beispiel Silicium sind wichtige Funktionswerkstoffe. Aufgrund ihrer Eigenschaft, Li-Ionen zu interkalieren, spielen sie eine wichtige Rolle bei der Herstellung von Batterieelektroden, Katalysatoren oder Solarzellen. Bei Batterien, wie z. B. Li-Ionen-Batterien ist die Zyklenfestigkeit bei gleichzeitiger Verhinderung oder Hemmung der Bildung sogenannter Dendriten oder Whisker eine kritische Anforderung. Mangelnde Zyklenfestigkeit vermindert die Brauchbarkeit des Energiespeichers beim häufigen, oftmals unvollständigen, Laden und Entladen, und Whisker können infolge innerer Kurzschlüsse die Batterie sogar zerstören. Es ist daher von großer Bedeutung, solche Vorgänge zu verhindern und funktionales Material in großer Menge und in der für die genannten Anwendungen erforderlichen Reinheit zugänglich zu machen.

In der Anmeldeschrift DE 102006059318 A1 wird ein Verfahren vorgeschlagen, poröse Siliciumpartikel herzustellen, die eine in der Literatur bekannte, typische Photolumineszenz zeigen. Dazu wird in einem Gemisch aus Monosilan und Argon oder Wasserstoff mittels Mikrowellen ein Plasma erzeugt und das Umsetzungsprodukt in einem Heißwandreaktor thermisch nachbehandelt. Es resultieren Nanopartikel mit massiven, amorphen Kernen. Die Nanopartikel können sich zu Aggregaten oder Agglomeraten zusammenlagern. Indem die Nanopartikel, Aggregate bzw. Agglomerate zunächst mit einer Lösung aus Flusssäure in Wasser und anschließend mit Salpetersäure in Wasser umgesetzt werden, erhält man, nachdem die Säure verbraucht und die Reaktion abgeklungen ist, poröse Siliciumpartikel. Solche Siliciumpartikel weisen offene Poren auf, die zum Beispiel als Kanäle für den Transport von Flüssigkeiten benutzt werden können.

Setzte man solche Siliciumpartikel in einer Batterie als Elektrodenmaterial oder als Separator ein, so wären die offenen Poren groß genug, um die Bildung von Whiskern zu begünstigen, die mit den für Li-Ionen-Batterien typischen Transportvorgängen im Elektrolyten und am Elektrodenmaterial einhergehen. Die Whisker durchdringen die Poren allmählich und stellen eine elektrische Verbindung zwischen den Batterieelektroden her, die gleichbedeutend mit einem inneren Kurzschluss ist. Eine mit einem solchen Material ausgestattete Batterie wäre nach wenigen Ladezyklen unbrauchbar.

Aufgabe der vorliegenden Erfindung war es daher, ein Verfahren zur Herstellung eines verbesserten Materials und das Material selbst bereit zu stellen, das für die Verwendung in Solarzellen und/oder Energiespeichern geeignet ist.

Überraschend wurde gefunden, dass bei der Umsetzung eines Silans oder Halogensilans in einem nichtthermischen Plasma, in einem Lichtbogen, oder allgemein in einer Pyrolyse, und einer anschließenden Dispersion der resultierenden Phase in einem Benetzungsmittel, einer anschließenden Destillation und einer Umsetzung des Destillates in einem Gemisch aus Wasser, Salpetersäure und/oder Flusssäure Hohlkörper erhalten werden, die eine Silicium enthaltende Hülle aufweisen.

Gegenstand der Erfindung ist daher ein Verfahren zur Herstellung von Hohlkörpern mit einer Silicium aufweisenden Hülle, indem man in einem Gas, das zumindest ein Silan der allgemeinen Formel SiₙH₂ₙ₊₂₋ₘXₘ mit n = 1 bis 4, m = 0 bis 2n+2 und X = Halogen aufweist,
(a) ein nichtthermisches Plasma mittels einer Wechselspannung der Frequenz f anregt, oder einen Lichtbogen betreibt, oder in dieses Gas elektromagnetische Energie vorzugsweise im Infrarotbereich einträgt, wobei eine resultierende Phase erhalten wird, die man
(b) in einem Benetzungsmittel dispergiert und abdestilliert, und man anschließend (c) das Destillat zumindest einmalig mit einem Gemisch aus zumindest zwei der Substanzen Flusssäure, Salpetersäure, Wasser in Kontakt bringt, wobei nach dem Abklingen oder Beenden der Umsetzungsreaktion des Destillates mit dem Gemisch ein fester Rückstand erhalten wird, der Hohlkörper mit einer Silicium aufweisenden Hülle enthält.

Die Erfindung wird im Folgenden näher erläutert.

Die erfindungsgemäß erhaltenen Hohlkörper weisen Silicium oder Verbindungen des Siliciums, vorzugsweise überwiegend Silicium in ihren Hüllen auf, gleichbedeutend damit, dass mindestens 50 % der Masse der verfahrensgemäß erhaltenen Hohlkörper Silicium ist. Die Hüllen der Hohlkörper können geschlossen oder offen sein.

Vorzugsweise kann bei der allgemeinen Formel des eingesetzten Silans n = 1 und/oder 2, X = Chlor und m = 0 bis 6 gewählt werden. Besonders bevorzugt wird Monosilan, TCS, STC oder ein Gemisch dieser Silane eingesetzt. Ganz besonders bevorzugt wird Monosilan eingesetzt.

Im Schritt (a) kann es vorteilhaft sein, hochreines Silan einzusetzen, gleichbedeutend mit einem Borgehalt von ca. 1 ppt bis 10 ppm und einem Phosphorgehalt von ca. 1 ppt bis 10 ppm.

Weiterhin kann es vorteilhaft sein, im Schritt (a) Mikrowellen oder elektromagnetische Energie im Bereich mittlerer Infrarotwellenlängen, gleichbedeutend mit 3 bis 50 µm, einzusetzen.

Für die Definition des nichtthermischen Plasmas bzw. einer Gasentladung im nichtthermischen Gleichgewicht wird auf die einschlägige Fachliteratur verwiesen, wie beispielsweise auf *"*Plasmatechnik: Grundlagen und Anwendungen - Eine Einführung", Autorenkollektiv, Carl Hanser Verlag, München/Wien; 1984, ISBN 3 446-13627-4.

Das nichtthermische Plasma kann durch eine Gasentladung in dem zumindest ein Silan enthaltenden Gasstrom erzeugt werden. Vorzugsweise wird das Plasma mittels transienter Hochspannungsentladung in einer bipolaren Elektrodenanordnung mit Bezugspotential- und Hochspannungselektrode erzeugt. Die Elektroden können mit einem Elektronen-Austrittshilfsmittel wie zum Beispiel BaO funktionalisiert bzw. ausgestattet sein.

Das Paschen-Gesetz besagt, dass die Zündspannung für die Plasmaentladung im Wesentlichen eine Funktion des Produktes, p·d, aus dem Druck des Gases, p, und dem Elektrodenabstand, d, ist. Der Elektrodenabstand wird auch mit Gasschlagweite, abgekürzt GAP, bezeichnet. Für die im Verfahren bevorzugte planare Elektrodenanordnung liegt dieses die Zündspannung definierende Produkt bevorzugt bei etwa 10 mm·bar. Die Entladung kann mittels verschiedenartiger Wechselspannungen und/oder gepulster Spannungen von 1 bis 1000 kV angeregt werden. Die Höhe der Spannung hängt in dem Fachmann bekannter Weise neben der Gasschlagweite der Entladungsanordung auch vom Prozessgas selbst ab. Die im Verfahren bevorzugt eingesetzte Spannung kann gepulst sein und bei vorzugsweise etwa 10 Kilo-Volt Peak (10 kVₚ) liegen und eine Impulshalbwertsdauer von gerundet 700 Nanosekunden und eine Wiederholrate von etwa 14.000 s⁻¹ aufweisen. Der zeitliche Verlauf dieser Spannung kann auch rechteckig, trapezförmig, oder stückweise aus einzelnen zeitlichen Verläufen zusammengesetzt sein. Jede Kombination des zeitlichen Verlaufs aus diesen Formen kann eingesetzt werden.

Die spezifische Energieflußdichte, die zur Erzeugung und/oder Aufrechterhaltung des nichtthermischen Plasmas eingetragen wird, kann von 0,01 bis 1000 W·s·cm² gewählt sein. Dabei ist es weiter bevorzugt, den spezifischen Energieeintrag mittels phasengenauer Messung der Momentanleistung mit einer Bandbreite von mindestens 250 kHz durchzuführen. Dabei kann die Messung der Momentanleistung in einem koaxialen Reaktor mit 100 cm² Entladungsfläche erfolgen. Ein koaxialer Reaktor ist vorzugsweise ein Rohrreaktor, insbesondere ein rotationssymmetrischer Rohrreaktor.

Der Energieeintrag zur Ausbildung des nicht-thermischen Plasmas erfolgt vorzugsweise in der Art, dass sich in dem sich ausbildenden Plasma möglichst homogene Bedingungen für die Umsetzung der Silane selbst beispielsweise mit Stickstoff und/oder Germanium enthaltenen Verbindungen einstellen. Dabei ist es besonders bevorzugt, das nichtthermische Plasma bei einer Spannung zu betreiben, bei der die Entladung die gesamte Elektrodenfläche bedeckt. Das kann bei einer dem Fachmann geläufigen Glimmentladung der Fall sein.

Das zumindest ein Silan enthaltende Gas kann mittels mindestens einer Düse eingebracht werden. Als Gas kann ein Gemisch umfassend zumindest ein Silan und zumindest ein inertes Verdünnungsgas eingesetzt werden. Eine bevorzugte spezifische Flussdichte des Gases mit 10 % Monosilan in Argon liegt gerundet bei 40 cm·s⁻¹, der Wert erhalten aus einem Volumenfluß von 2400 cm³·min⁻¹ pro cm² Elektrodenfläche. Die Verweilzeit, während der sich die Teilchen in dem Reaktionsraum aufhalten und zumindest teilweise in dem Plasma umgesetzt werden, liegt bei bis zu 10.000 ms, vorzugsweise in einem Bereich von 1 bis 1000 ms. Die Umsetzung im Plasma führt zur Erzeugung chemischer Radikale, aus denen sich wiederum Silicium enthaltende Partikel bilden. Diese Partikel können neben Silicium ebenfalls SiN, SiO und/oder SiC aufweisen, abhängig von der Zusammensetzung des Gases.

Die resultierende Phase weist diese Partikel auf und ist pulverförmig. Die Partikel können einzeln auftreten, und zwar mit typischen Durchmessern der Partikel von 3 bis 500 nm, vorzugsweise von 50 bis 300 nm. Ebenfalls können die Partikel in Form von Clustern zusammengelagert sein. Die Cluster können gebildet werden, indem einzelne kristalline Partikel bei der Herstellung aneinanderwachsen und optional weiterwachsen. Sowohl die isolierten Partikel, als auch die Cluster weisen mindestens eine, bevorzugt genau eine kristalline Phase an reinem Silicium auf. Die Cluster können als lineare Ketten, Drähten ähnlich, oder auch räumlich verzweigt vorliegen.

Hält man während Schritt (a) oder am Ende des Schrittes (a) das Gas bei einer Temperatur von 100 bis 500 °C, vorzugsweise bei 500 °C, so weist die resultierende Phase überwiegend Partikel auf, die nicht zu Clustern agglomeriert sind. Wählt man Temperaturen größer als 500 °C, bevorzugt eine Temperatur von 550 °C bis 1300 °C, so erhält man überwiegend zu Clustern agglomerierte Partikel.

Die Cluster können eine Größe von 20 nm bis 6 µm aufweisen, vorzugsweise von 20 nm bis 3 µm, weiter bevorzugt von 400 nm bis 6 µm, besonders bevorzugt von 100 nm bis 3 µm, weiterhin besonders bevorzugt von 300 nm bis 3 µm, 500 nm bis 3 µm, 1 bis 3 µm.

Die die Cluster und/oder Partikel aufweisende resultierende Phase verlässt den Reaktionsraum und/oder kann in dem Reaktionsraum abgeschieden sein.

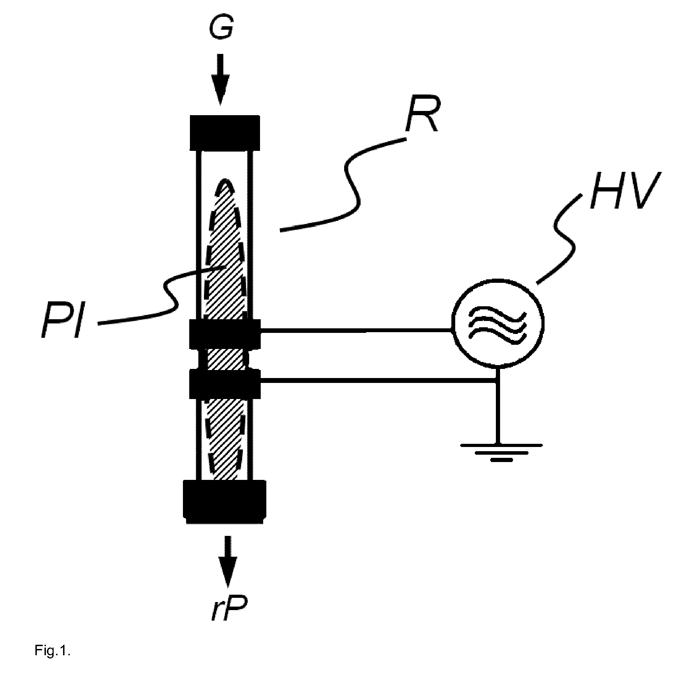

Unter dem Reaktionsraum wird im Sinne der Erfindung das Innere des Reaktors verstanden. In diesem Volumen findet die Plasmaentladung, Glimmentladung oder Pyrolyse, oder das Brennen des Lichtbogens statt, oder es wird die elektromagnetische Energie eingetragen. Die **Fig. 1** zeigt schematisch und beispielhaft einen solchen Reaktor (R). Erfindungsgemäß wird in den Reaktor (R) das Gas (G) eingeleitet, in welchem mittels eines Gerätes zur Erzeugung einer Wechselspannung (HV) eine Plasmaentladung (Pl) erzeugt wird. Schematisch gezeigt ist die den Reaktionsraum verlassende resultierende Phase (rP). Damit die resultierende Phase nicht gänzlich in dem Reaktionsraum abgeschieden wird oder verbleibt, kann diese mittels Vakuumpumpe aus dem Reaktor abgezogen werden. Einsatzmöglichkeiten von Vorrichtungen zum Evakuieren und geeignete Drücke bzw. Gasströme sind dem Fachmann bekannt.

In dem Schritt (a) des erfindungsgemäßen Verfahrens kann ein Plasmareaktor, Induktionsreaktor, Pyrolyseofen, oder Lichtbogenofen eingesetzt werden, und der Reaktionsraum des Reaktors oder Ofens kann vorzugsweise aus Glas, Oxidkeramik, Carbidkeramik oder Graphit gefertigt sein.

Besonders bevorzugt kann metallfreie Keramik, metallfreies Glas, oder Keramik oder Glas, die oder das hohe Reinheiten aufweist, eingesetzt werden. Vorzugsweise wird ein Reaktor eingesetzt, der als Modul aus Teilelementen aufgebaut oder aus einem Stück gefertigt sein kann. Der Energieeintrag kann bevorzugt auf elektromagnetischem Wege, zum Beispiel mittels Plasmaelektroden erfolgen.

Das Benetzungsmittel, das in Schritt (b) eingesetzt wird, kann ausgewählt sein aus zumindest einem Alkohol, Wasser, Salpetersäure, oder einem Gemisch aus diesen Substanzen. Zumindest ein Alkohol und Wasser werden bevorzugt eingesetzt.

Im Schritt (b) des erfindungsgemäßen Verfahrens kann es vorteilhaft sein, die resultierende Phase zunächst zu entgasen und anschließend in einem Benetzungsmittel, ausgewählt aus Wasser und Ethanol, zu dispergieren.

Für das Entgasen kann eine Verdichtungsstufe eingesetzt werden. Bevorzugt kann die Phase in hochreines Wasser oder in ein Gemisch aus hochreinem Wasser und Ethanol dispergiert werden und anschließend abdestilliert werden. Besonders bevorzugt kann die Phase in Ethanol dispergiert und anschließend abdestilliert werden. Vorzugsweise werden pro Gramm am Ende des Schrittes (b) erhaltenem Destillat eine Menge von 10 bis 50 g Wasser, besonders bevorzugt 15 bis 25 g Wasser eingesetzt werden. Weiterhin bevorzugt können pro Gramm am Ende des Schrittes (b) erhaltenem Destillat von 10 bis 50 g Alkohol, besonders bevorzugt 15 bis 25 g Alkohol eingesetzt werden. Ganz besonders bevorzugt werden pro Gramm am Ende des Schrittes (b) erhaltenem Destillat gleiche Massen von Wasser und Alkohol, vorzugsweise Ethanol, eingesetzt.

Im Schritt (c) des erfindungsgemäßen Verfahrens wird das Destillat vorzugsweise zunächst mit einem Gemisch aus Wasser und Salpetersäure und anschließend mit Flusssäure in Kontakt gebracht, wobei nach dem Abklingen der Umsetzungsreaktion ein fester Rückstand erhalten ist, der gewaschen, filtriert und/oder getrocknet wird.

Bevorzugt wird der Schritt (c) einmal, weiterhin bevorzugt zumindest einmal durchgeführt. Während zumindest einer Durchführung des Schrittes (c) werden pro Gramm des am Ende des Schrittes (b) erhaltenen Destillates bevorzugt von 3 bis 10 g, besonders bevorzugt von 3 bis 6 g Salpetersäure eingesetzt. Die Konzentration der Salpetersäure liegt bevorzugt bei 70 %. Des Weiteren werden während zumindest einer Durchführung des Schrittes (c) pro Gramm des am Ende des Schrittes (b) erhaltenen Destillates bevorzugt von 0 bis 70 g Flusssäure HF eingesetzt, besonders bevorzugt von 0 bis 60 g HF, weiterhin besonders bevorzugt von 0 bis 45 g HF und ganz besonders bevorzugt von 0 bis 10 g HF eingesetzt. Die Konzentration der Flusssäure kann von 4 bis 12 %, bevorzugt von 5 bis 10 % gewählt sein.

Kommt die Umsetzungsreaktion während zumindest einer Durchführung des Schrittes (c) ohne weiteres Zutun zum Stillstand, so wird dies im Rahmen der Erfindung mit "*Abklingen*" bezeichnet. Das Erkennen des Abklingens der Umsetzungsreaktion im Schritt (c) ist dem Fachmann geläufig. Erfindungsgemäß ereignet sich das Abklingen, falls die Säure oder die Säuren vollständig umgesetzt ist oder sind und das Destillat nicht vollständig umgesetzt wurde. In diesem Fall wird der feste Rückstand, der Hohlkörper mit einer Silicium aufweisenden Hülle enthält, erfindungsgemäß erhalten.

In einer alternativen Ausführungsform der Erfindung wird die Umsetzungsreaktion während zumindest einer Durchführung des Schrittes (c) abgebrochen, unterbrochen oder stark verlangsamt, bevor das Destillat vollständig umgesetzt wird. Dies wird im Rahmen der Erfindung mit "*Beenden*" bezeichnet. Auch in diesem Fall wird der feste Rückstand, der Hohlkörper mit einer Silicium aufweisenden Hülle enthält, erfindungsgemäß erhalten.

Ganz allgemein ist das vollständige Umsetzen des Destillates bei jeder Durchführung des Schrittes (c) zu vermeiden. Die dafür erforderliche Vorgehensweise ist dem Fachmann bekannt. Denn die Umsetzungsreaktion im Schritt (c) ist eine Ätzreaktion. Findet keine Ätzreaktion mehr statt und ist optisch nur noch eine Flüssigkeit zu erkennen, so ist kein fester Rückstand vorhanden. Dann hat man eine resultierende Phase erneut erfindungsgemäß herzustellen.

Das Vorhandensein des festen Rückstandes ist für den Fachmann einfach festzustellen, denn der feste Rückstand ist optisch von der Flüssigkeit wohl unterschieden, die beim Abklingen oder Beenden der Umsetzungsreaktion während Schritt (c) erhalten wird.

Vorzugsweise ist bei einer Durchführung des Schrittes (c) eine derartige Menge Gemisch mit Säure oder Säuren einzusetzen, dass das Destillat nicht vollständig umgesetzt wird. Bevorzugt wird ein Abklingen der Umsetzungsreaktion erhalten, indem während einer Durchführung des Schrittes (c) von 3 bis 5 g, besonders bevorzugt 5 g Salpetersäure pro Gramm Destillat eingesetzt werden.

Gleichfalls ist es bevorzugt, die Umsetzungsreaktion zu beenden, indem während zumindest einer Durchführung des Schrittes (c) das Gemisch mit Wasser verdünnt und/oder das Destillat dem Gemisch vor dem Abklingen entzogen wird, beispielsweise durch Abfiltern in dem Fachmann bekannter Weise.

Weiterhin ist es bevorzugt, das Beenden der Umsetzungsreaktion auszuwählen, indem während Schritt (c) Wasser, besonders bevorzugt destilliertes oder gereinigtes Wasser hinzugegeben wird.

In dem erfindungsgemäßen Verfahren kann der feste Rückstand gewaschen, filtriert und/oder getrocknet werden, oder man beendet die Umsetzungsreaktion vorzugsweise, bevorzugt durch Zugabe von Wasser, wobei man den festen Rückstand anschließend wäscht, filtriert und/oder trocknet. Besonders bevorzugt kann dieser über eine Membran, vorzugsweise über eine Cellulosemischestermembran filtriert und gewaschen und bei einer Temperatur von 20 °C bis 100 °C, vorzugsweise bei 60 °C getrocknet, ganz besonders bevorzugt unter Vakuum getrocknet werden.

Die Zeit, während der die Umsetzungsreaktion laufen gelassen wird, kann satzweise bis zu 3,5 Tagen betragen. Vorzugsweise lässt man die Umsetzungsreaktion abklingen.

Während zumindest einer Durchführung des Schrittes (c) kann die Umsetzungsreaktion beendet werden oder ohne weiteres Zutun abklingen. Es kann weiterhin vorteilhaft sein, den Schritt (c) mehrfach durchzuführen. Das Abklingen und/oder Beenden ist bevorzugt während einer einmaligen Durchführung, besonders bevorzugt während der ersten und der zweiten Durchführung des Schrittes (c) ausgewählt werden.

Vorzugsweise kann bei der zumindest ersten Wiederholung des Schrittes (c) nach dem Abklingen oder Beenden der Reaktion dem Umsetzungsprodukt erneut Wasser und Salpetersäure dazugegeben werden.

Besonders bevorzugt können nach dem Abklingen oder Beenden der Reaktion dem Umsetzungsprodukt wiederholt kleine Mengen HF hinzugefügt werden, gleichbedeutend mit wiederholtem Zugeben von HF in jeweils einer Menge von 5 bis 50 %, bezogen auf die Masse hinzugefügter Salpetersäure.

Gleichfalls Gegenstand der Erfindung sind Hohlkörper mit einer Silicium aufweisenden Hülle, die nach dem erfindungsgemäßen Verfahren erhalten sind.

Die Hohlkörper können regelmäßige oder unregelmäßige Formen aufweisen. Sie können beispielsweise kugelförmig, eiförmig oder unregelmäßig geformt sein. Die Hohlkörper können als einzelne Körper vorliegen. Einzelne Körper können auch zu Clustern aneinandergewachsen sein. Die Cluster könne auch als Agglomerate bezeichnet werden, wobei vorliegend unter einem Cluster aneinandergewachsene bzw. aneinander geschmolzene Körper verstanden werden. So können die Körper Cluster ausbilden, in denen mindestens zwei Körper an ihren Oberflächen aneinander geschmolzen sind. Diese Cluster können als lineare Ketten, in Form von Drähten oder auch verzweigt vorliegen und eine Größe haben, die der Fachmann bei den Partikeln kennt, die als Elektrodenmaterial in Batterien verwendet sind, beispielsweise in Zink-Kohle, Alkali- oder Li-Ionen-Batterien. Vorzugsweise liegen diese Größen im Bereich von 20 nm bis 6 µm.

Ohne an eine Theorie gebunden zu sein, vermuten die Erfinder, dass bei der Ausbildung der Hülle im Unterschied zu dem ganz oder teilweise umschlossenen Volumen der sogenannte *Kirkendall-Effekt* eine treibende Wirkung sein könnte. Denn während des Schrittes (c) diffundieren stickstoffhaltige Verbindungen rascher aus dem Inneren der Partikel heraus, als siliciumhaltige Verbindungen oder Si-Atome oder Si-Ionen in das Innere der sich umsetzenden Partikel hinein.

Vorzugsweise weist die Silicium aufweisende Hülle der erfindungsgemäßen oder erfindungsgemäß erhaltenen Hohlkörper eine transmissionselektronenmikroskopisch ermittelte Dicke von 5 bis 40 nm auf.

Ebenfalls Gegenstand der Erfindung ist die Verwendung der erfindungsgemäßen oder erfindungsgemäß erhaltenen Hohlkörper zur Herstellung von Solarzellen oder von Elektrodenmaterial in Energiespeicherzellen.

Die Erfindung wird im Folgenden anhand von Beispielen näher erläutert.

### Beispiel 1.

In ein Gas aus Monosilan (SiH₄) wurde elektromagnetische Energie mit einer Leistung von etwa 100 W und in einem dem Fachmann bekannten zur Temperatur von 1150°C korrespondierenden Wellenlängenbereich von etwa 500 nm bis 4 µm eingetragen.

Die resultierende Phase, die 1,1 g pulveriges Silicium aufwies, wurde in einem Benetzungsmittel aus 20 g Ethanol dispergiert und abdestilliert.

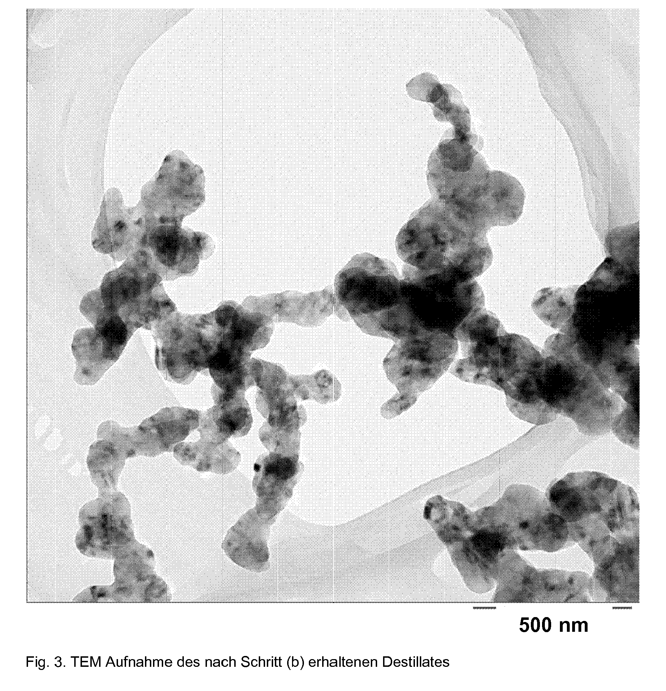

Das Destillat, gezeigt in einer transmissionselektronenmikroskopischen (TEM) Aufnahme (**Fig. 3**), wurde anschließend mit einem Gemisch aus 20 g H₂O und 5 g 70-prozentiger HNO₃ versetzt. Die Angaben *"70-prozentige HNO₃"* und "*HNO₃ (70* %)" sind im Rahmen der vorliegenden Erfindung gleichbedeutend und dem Fachmann geläufig als ein Gemisch aus HNO₃ und Wasser in den entsprechenden Mengenanteilen.

Nach dem Ablauf von 3,5 Tagen war die Umsetzung abgeklungen, und es lag ein heller Rückstand vor. Dieser wurde mit 10 g 5-prozentiger Flusssäure versetzt. Nach dem Abklingen der damit bewirkten Umsetzungsreaktion wurde ein fester Rückstand erhalten, den man abfiltrierte.

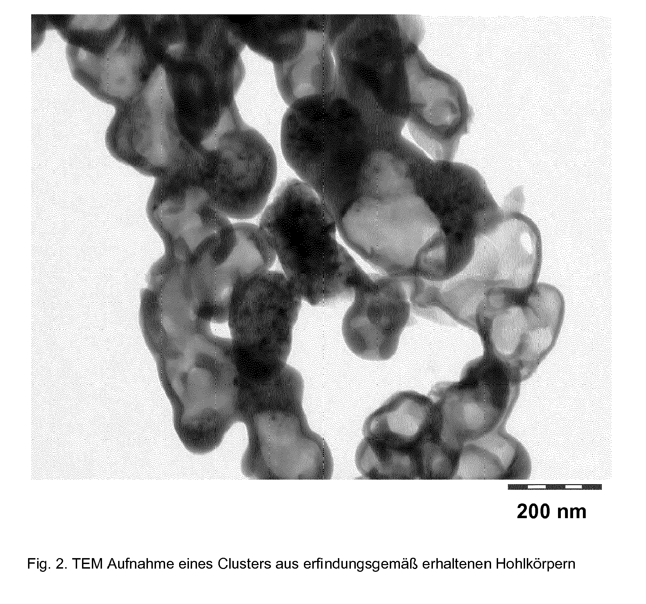

In der TEM Aufnahme zeigte dieser feste Rückstand die erfindungsgemäß erhaltenen Hohlkörper (**Fig. 2**).

### Beispiel 2.

Wie Beispiel 1, jedoch mit folgenden Unterschieden.

Nachdem das Destillat mit einem Gemisch aus 20 g H₂O und 5 g HNO₃ (70 %) versetzt worden und man die Umsetzungsreaktion 1,2 Tage hat stattfinden lassen, wurde erneut ein Gemisch aus 20 g H₂O und 5 g HNO₃ (70 %) dazugegeben.

Nach dem Abklingen der Umsetzungsreaktion wurden 40 g 5-prozentige Flusssäure dazugegeben. Nach dem Abklingen der nun stattfindenden Umsetzungsreaktion wurde ein fester Rückstand erhalten, den man abfiltrierte. Man erhielt die erfindungsgemäßen Hohlkörper.

### Beispiel 3.

Wie Beispiel 1, jedoch mit folgenden Unterschieden.

Die resultierende Phase wurde in einem Gemisch aus 5 g H₂0 und 10 g HNO₃ (70 %) dispergiert und destilliert.

Nachdem das Destillat mit 5 g HNO₃ (70 %) und anschließend mit 45 g 10-prozentiger Flusssäure versetzt worden war, ließ man die Umsetzungsreaktion für eine Dauer von 3 Tagen stattfinden.

Nach Ablauf dieser Dauer wurde die Umsetzungsreaktion durch die Zugabe von 100 g Wasser beendet.

Nach dem Beenden war ein fester Rückstand erhalten, den man abfiltrierte und der die erfindungsgemäßen Hohlkörper aufwies.

### Vergleichsbeispiel 1.

Wie Beispiel 3, jedoch mit dem Unterschied, dass man die Umsetzungsreaktion nach der Zugabe der 45 g 10-prozentiger Flusssäure nicht beendete, sondern abklingen ließ.

Es wurde kein fester Rückstand erhalten.

## Patentansprüche

1. Verfahren zur Herstellung von Hohlkörpern mit einer Silicium aufweisenden Hülle, indem man
in einem Gas, das zumindest ein Silan der allgemeinen Formel SiₙH₂ₙ₊₂₋ₘXₘ mit n = 1 bis 4, m = 0 bis 2n+2 und X = Halogen aufweist,
(a) ein nichtthermisches Plasma mittels einer Wechselspannung der Frequenz f anregt,
oder einen Lichtbogen betreibt,
oder in dieses Gas elektromagnetische Energie im Infrarotbereich einträgt,
wobei eine resultierende Phase erhalten wird, die man
(b) in einem Benetzungsmittel dispergiert und abdestilliert, und man anschließend
(c) das Destillat zumindest einmalig mit einem Gemisch aus zumindest zwei der Substanzen Flusssäure, Salpetersäure, Wasser in Kontakt bringt,
wobei nach dem Abklingen oder Beenden der Umsetzungsreaktion des Destillates mit dem Gemisch ein fester Rückstand erhalten wird, der Hohlkörper mit einer Silicium aufweisenden Hülle enthält.

2. Verfahren nach Anspruch 1, wobei im Schritt (a) ein Plasmareaktor, Induktionsreaktor, Pyrolyseofen, oder Lichtbogenofen eingesetzt wird, und der Reaktionsraum des Reaktors oder Ofens aus Glas, Oxidkeramik, Carbidkeramik oder Graphit gefertigt ist.

3. Verfahren nach Anspruch 1, wobei im Schritt (b) die resultierende Phase zunächst entgast und anschließend in einem Benetzungsmittel, ausgewählt aus Wasser und Ethanol, dispergiert wird.

4. Verfahren nach Anspruch 1, wobei im Schritt (c) das Destillat zunächst mit einem Gemisch aus Wasser und Salpetersäure und anschließend mit Flusssäure in Kontakt gebracht wird, wobei
nach dem Abklingen der Umsetzungsreaktion ein fester Rückstand erhalten ist, der gewaschen, filtriert und/oder getrocknet wird.

5. Verfahren nach Anspruch 1 oder 4, wobei man den festen Rückstand wäscht, filtriert und/oder trocknet, oder man die Umsetzungsreaktion beendet, vorzugsweise durch Zugabe von Wasser, und den festen Rückstand anschließend wäscht, filtriert und/oder trocknet.

6. Hohlkörper mit einer Silicium aufweisenden Hülle, erhalten nach einem Verfahren gemäß einem der Ansprüche 1 - 5.

7. Hohlkörper nach Anspruch 6, deren Silicium aufweisende Hülle eine transmissionselektronenmikroskopisch ermittelte Dicke von 5 bis 40 nm aufweist.

8. Verwendung der Hohlkörper gemäß Anspruch 6 oder 7 zur Herstellung von Solarzellen oder von Elektrodenmaterial in Energiespeicherzellen.
